(19) **Europäisches Patentamt / European Patent Office / Office européen des brevets**

(11) **EP 3 855 516 A1**

(12) # EUROPEAN PATENT APPLICATION
published in accordance with Art. 153(4) EPC

(43) Date of publication:
**28.07.2021 Bulletin 2021/30**

(21) Application number: **19861334.1**

(22) Date of filing: **30.08.2019**

(51) Int Cl.:
**H01L 33/56** (2010.01)   **B22F 1/00** (2006.01)
**B22F 1/02** (2006.01)   **B22F 3/02** (2006.01)
**B22F 9/00** (2006.01)   **B23K 35/26** (2006.01)
**C22C 12/00** (2006.01)   **C22C 13/02** (2006.01)
**H01B 1/00** (2006.01)   **H01B 1/22** (2006.01)
**B22F 9/24** (2006.01)

(86) International application number:
**PCT/JP2019/034081**

(87) International publication number:
**WO 2020/059461 (26.03.2020 Gazette 2020/13)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **20.09.2018 JP 2018175739**

(71) Applicants:
- **Kyoritsu Chemical Co., Ltd.**
  **Tokyo 100-0011 (JP)**
- **SHIN-ETSU CHEMICAL CO., LTD.**
  **Tokyo 100-0004 (JP)**

(72) Inventors:
- **OYAMA, Yu**
  **Kisarazu-shi, Chiba 292-0834 (JP)**
- **KINDA, Hidefumi**
  **Tokyo 100-0011 (JP)**
- **KURITA, Daisuke**
  **Tokyo 100-0011 (JP)**
- **MATSUI, Harunobu**
  **Joetsu-shi, Niigata 942-8601 (JP)**
- **HARADA, Daijitsu**
  **Joetsu-shi, Niigata 942-8601 (JP)**
- **TAKEUCHI, Masaki**
  **Joetsu-shi, Niigata 942-8601 (JP)**

(74) Representative: **Pfenning, Meinig & Partner mbB**
**Patent- und Rechtsanwälte**
**Theresienhöhe 11a**
**80339 München (DE)**

(54) **COMPOSITION FOR SEALING**

(57)   A sealing composition which can be handled in a semi-cured state and can obtain a sintered body having excellent joining strength and sealing performance is provided. A sealing composition including a solder powder, coated silver particles including silver core particles and a coating agent arranged on a surface of the silver core particles, and a solvent is provided. Further, a sintering temperature (T2) of the coated silver particles and a boiling point (T3) of the solvent satisfy T2≤T3.

Fig. 1C

## Description

### Technical Field

The present disclosure relates to a sealing composition, and more particularly to a sealing composition used in sealing an ultraviolet light source.

### Background Art

Recently, UltraViolet Light Emitting Diodes (UV-LEDs) have attracted attention as an ultraviolet light source. The UV-LEDs are expected to be used as ultraviolet light sources in place of mercury lamps, because, for example, they are smaller, more efficient, have a longer lifetime, have a shorter warm-up time, and have less environmental impact as compared to mercury lamps according to related art.

An optical element which is a light source of an LED is generally used in a sealed state. In visible light LEDs, an organic matter such as resin has been widely used as a sealant. However, the UV-LEDs in which organic sealants are used have a problem that they are degraded due to ultraviolet light.

As a method of sealing an optical element in a UV-LED, for example, a method of sealing an optical element by bonding a window material such as glass to a substrate of the optical element using an inorganic sealant has been studied.

As the inorganic sealant, a method using, for example, a solder or metal nanoparticles has been studied.

Patent Literature 1 discloses a composition for a bonding agent composed of three components: metal nanoparticles having low-temperature sinterability coated with a coating material designed in advance for peeling at a predetermined temperature; a solder powder having a melting point lower than the peeling temperature; and a pasty agent that vaporizes at a temperature lower than the melting point. According to Patent Literature 1, the solder is firmly bonded to a substrate by performing melt-bonding under a heating condition in which a sintering phenomenon occurs after the solder is melted.

Patent Literature 2 discloses a synthetic quartz glass lid including an adhesive, which is a low melting point metallic glass including tellurium and silver and further including one or more kinds of elements selected from the group consisting of tungsten, vanadium, phosphorus, barium, and zirconium, at a specific position of a specific window material.

The present inventors have disclosed in Patent Literature 3 coated silver particles having excellent corrosion resistance, particle size stability, particle dispersibility in a medium, and sinterability, which include silver core particles, and a plurality of aliphatic carboxylic acid molecules arranged on the surface of the silver core particles at a density of 2.5 to 5.2 molecules per 1 $nm^2$.

### Citation List

### Patent Literature

Patent Literature 1: Japanese Patent No. 5442566
Patent Literature 2: Japanese Unexamined Patent Application Publication No. 2018-026548
Patent Literature 3: Japanese Unexamined Patent Application Publication No. 2017-179403

### Summary of Invention

### Technical Problem

As a method of bonding a substrate to a window material, there is known a method in which one of the substrate and the window material is coated with a sealant, semi-cured (B-staged) and fixed, and the other one of them is arranged and bonded on the B-staged sealant. According to such a method, it is possible to store and transport the sealant in a semi-cured state, which is excellent in handleability. B-staging of organic sealants has been relatively easy. However, organic sealants are susceptible to degradation due to ultraviolet light and are not suitable for UV-LED sealants. On the other hand, when a solder is used as an inorganic sealant, the joining strength is sometimes insufficient. Further, when a nano paste is used as the sealant, the B-staging can be relatively easily performed and the joining strength is excellent, but there is a problem in the sealing performance, because the resultant sintered body is likely to become porous.

The technique disclosed in Patent Literature 1 is for heat-treating the specific joining composition in a heating apparatus in which the temperature is raised to the peeling temperature of the coating material and not for semi-curing the composition for a bonding agent before use.

The technique of Patent Literature 2 has a semi-cured adhesive in a peripheral part of a synthetic quartz glass lid. However, since the sintering time of the adhesive at the time of joining is long, there is a need for a sealant that can be sintered in a shorter time.

The present disclosure has been made in light of such circumstances, and an object of the present disclosure is to provide a sealing composition which can be handled in a semi-cured state and can obtain a sintered body having excellent joining strength and sealing performance.

**Solution to Problem**

A sealing composition according to an embodiment includes a solder powder; coated silver particles comprising silver core particles and a coating agent arranged on a surface of the silver core particles; and a solvent. A sintering temperature (T2) of the coated silver particles and a boiling point (T3) of the solvent satisfy a following Formula (1).

$$T2 \leq T3 \ \dots \ Formula \ (1)$$

**Advantageous Effects of Invention**

According to the present disclosure, it is possible to provide a sealing composition which can be handled in a semi-cured state and can obtain a sintered body having excellent joining strength and sealing performance.

**Brief Description of Drawings**

Figs. 1A to 1C are schematic process diagrams showing an example of a method of using a sealing composition according to this embodiment, and Fig. 1A is a schematic cross-sectional view showing an example of a sealing composition applied onto a glass substrate;

Fig. 1B is a schematic cross-sectional view showing an example of a sealing composition in a semi-cured state;

Fig. 1C is a schematic cross-sectional view showing an example of a joined part formed using the sealing composition according to this embodiment;

Fig. 2 is a schematic diagram showing an example of a step of bonding a light source substrate to a semi-cured product of the sealing composition; and

Fig. 3 is a graph showing a result of a TG-DTA measurement of a sealing composition according to Example 1.

**Description of Embodiments**

[Sealing composition]

A sealing composition according to this embodiment includes a solder powder, coated silver particles comprising silver core particles and a coating agent arranged on a surface of the silver core particles, and a solvent. A sintering temperature (T2) of the coated silver particles and a boiling point (T3) of the solvent satisfy a following Formula (1).

$$T2 \leq T3 \ \dots \ Formula \ (1)$$

The above sealing composition according to the embodiment can be handled in a semi-cured state, and a sintered body excellent in joining strength and sealing performance can be obtained.

The sealing composition according to this embodiment includes at least the solder powder, the coated silver particles, and the solvent having the boiling point equal to or higher than the sintering temperature of the coated silver particles, and may further include other components as necessary. First, each component included in the sealing composition according to this embodiment will be described, and then a method of using the sealing composition and the reason for achieving the above effect will be described.

<Solder powder>

The solder powder used in this embodiment is an alloy powder that can be melted at a relatively low temperature.

Since the sealing composition according to this embodiment includes the solder powder having a relatively low melting point, it is excellent in sealing joining performance at a low temperature.

The solder used as the solder powder includes, for example, tin (Sn), and further includes an alloy including an element such as bismuth (Bi), zinc (Zn), lead (Pb), antimony (Sb), copper (Cu), indium (In), silver (Ag), and may include other elements which are inevitably mixed. Specific examples of the solder include Sn-Pb-based, Pb-Sn-Sb-based, Sn-Sb-based, Sn-Pb-Bi-based, Sn-Bi-based, Sn-Zn-Bi-based, Sn-Zn-based, Sn-Cu-based, Sn-Pb-Cu-based, Sn-In-based, Sn-Ag-based, Sn-Pb-Ag-based, and Pb-Ag-based solder. In this embodiment, one kind of solder may be used alone or two or more kinds of solders may be used in combination.

The solder powder may be produced by mixing desired metal by a known method, or a commercially available solder powder may be used.

In this embodiment, it is preferable to use a lead-free solder (Sn-Sb-based, Sn-Bi-based, Sn-Zn-Bi-based, Sn-Zn-based, Sn-Cu-based, Sn-In-based, Sn-Ag-based solder, etc.) in terms of reducing the burden on the environment, and among them, it is more preferable to use an Sn-Bi-based solder, an Sn-Zn-Bi-based solder, or an Sn-Zn-based solder. A sintered body having high strength and excellent sealing performance is obtained by using a solder including Zn. By using a solder including Bi having excellent wettability to glass or the like, a sintered body having excellent adhesion and high joining strength can be obtained. Further, by using a solder including Sn excellent in wettability to sintered silver described later, holes in the sintered silver can be filled to form a stronger sintered body.

The average primary particle diameter of the solder powder is not particularly limited, and may be appropriately selected from those having, for example, 0.5 to 500 $\mu$m. In the present disclosure, the average primary particle diameter of the solder powder is an arithmetic average value of the primary particle diameters of any 20 solder powders observed by a Scanning Electron Microscope (SEM). The particle shape may be a spherical shape, an substantially spherical shape, a plate-like shape or a rod-like shape.

A melting point (T1) of the solder powder varies depending on the metal content ratio, etc., but is generally within the range of 135 to 250 °C, preferably within the range of 135 to 200 °C, and more preferably within the range of 135 to 155 °C. The melting point (T1) of the solder powder is preferably equal to or lower than the sintering temperature (T2) of the coated silver particles described later.

When an Sn-Bi-based solder, an Sn-Zn-Bi-based solder, or an Sn-Zn-based solder is used as the solder powder, the melting point (T1) of the solder powder is, for example, within a range of 135 to 200 °C. Within this range, the melting point of the Sn-Bi-based solder can be made to fall within the range of 135 to 155 °C by adjusting the content ratio of Sn and Bi, etc. When the Sn-Bi-based solder is used, the ratio of Sn to Bi is not particularly limited, but in terms of the joining strength and the sealing performance, the mass ratio is preferably 3: 7 to 8: 2.

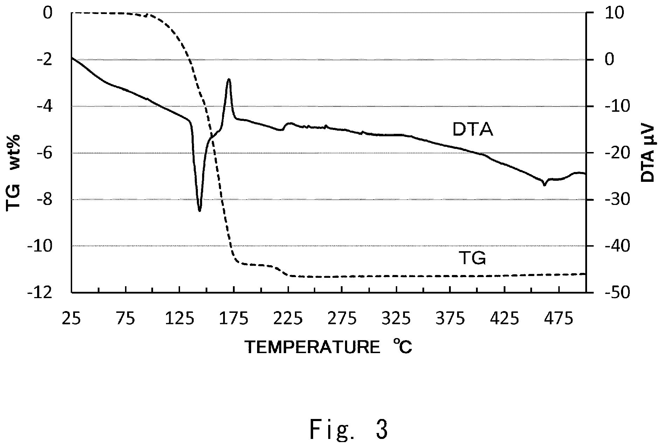

When the solder powder is melted, heat absorption occurs with the phase change. Therefore, the melting point (T1) of the solder powder can be determined, for example, by the position of the endothermic peak in the TG-DTA measurement (thermogravimetry and differential thermal analysis) (143 °C in the example of Fig. 3).

<Coated silver particle>

The coated silver particles used in this embodiment include the silver core particles and the coating agent arranged on the surface of the silver core particles. Thus, the surface of the silver core particles is protected by the coating agent to suppress oxidation.

In this embodiment, the coated silver particles can be selected from those having the sintering temperature (T2) of the coated silver particles and the boiling point (T3) of the solvent described later satisfying the following Formula (1).

$$T2 \leq T3 \;\ldots \qquad Formula \; (1)$$

By selecting such coated silver particles, the coated silver particles are sintered in a state in which the solvent remains in the sealing composition. Therefore, the coated silver particles have fluidity at the time of sintering, and it becomes difficult for holes to be generated in the sintered body. As a result, a sintered body excellent in adhesion and joining strength can be obtained. The sintering temperature (T2) of the coated silver particles can be adjusted, for example, within the range of 100 to 300 °C, preferably within the range of 100 to 200 °C, or may be within the range of 100 to 135 °C.

When the coated silver particles are sintered, heat is generated as the total surface energy decreases. Therefore, the sintering temperature (T2) of the coated silver particles can be determined, for example, by the position of the exothermic peak (160 to 185 °C in the example of Fig. 3) in the TG-DTA measurement.

The sintering temperature (T2) of the coated silver particles is preferably equal to or higher than the melting point (T1) of the solder powder. When T1 $\leq$ T2, the temperature can be controlled such that the coated silver particles are sintered after the solder powder is melted. In this case, the sintering temperature (T2) of the coated silver particles can be adjusted, for example, within the range of 155 to 300 °C, and preferably within the range of 155 to 200 °C.

(Silver core particles)

The average primary particle diameter of the silver core particles is not particularly limited, and can be appropriately selected with respect to the sintering temperature or the like. Specifically, the average primary particle diameter of the silver core particles can be appropriately selected within the range of 500 nm or less, and more preferably within the range of 400 nm or less, and still more preferably within the range of 300 nm or less, in terms of low-temperature sinterability. The average primary particle diameter of the silver core particles is usually 1 nm or more, preferably 5 nm or more, and more preferably 20 nm or more. The average primary particle diameter of the silver core particles is an arithmetic average value of primary particle diameters of any 20 silver core particles observed by SEM.

The shape of the silver core particles is not particularly limited, and may be substantially spherical including a true spherical, plate-like, rod-like, etc. According to a method of producing coated silver particles described later, substantially spherical silver core particles approximable to be substantially spherical can be obtained. The particle diameter of the coated silver particles can be determined by an SEM observation.

The silver core particles are particles substantially made of silver, but may include a proportion of silver oxide, silver hydroxide, and other impurities up to an amount that does not impair the effect of the present disclosure. The proportion of the content of silver oxide and silver hydroxide to silver core particles is preferably 5 mass% or less in terms of joining strength.

(Coating agent)

Known organic or inorganic materials that can adhere to common metal nanoparticles are used as the coating agent arranged on the surface of the silver core particles. As the organic material, organic molecules such as an aliphatic carboxylic acid, an aliphatic aldehyde, an aliphatic alcohol, an aliphatic amine, an organic polymer or the like is used, and as the inorganic material, silica, graphite or the like is used. By arranging the coating agent on the surface of the silver core particles, oxidation of the silver core particles and bonding between the silver core particles are suppressed, and the silver core particles can be handled in a stable state.

The coating agent is preferably separated from the surface of the silver core particles with temperature responsiveness. A sintered body having high joining strength can be obtained by desorption of the coating agent from the silver core particles by temperature elevation. The temperature at which the coating agent separates from the silver core particles (separation temperature) is preferably at or above the sintering temperature of the coated silver particles, more preferably at or above 10 °C higher than the sintering temperature of the coated silver particles, and still more preferably at or above 25 °C higher than the sintering temperature of the coated silver particles. On the other hand, the separation temperature of the coating agent is preferably at or under 50 °C higher than the sintering temperature of the coated silver particles (the separation temperature of the coating agent is preferably (the sintering temperature of coated silver particles + 50 °C) or less). Here, the temperature at which the coating agent separates from the coated silver particles (the separation temperature) can be set to a temperature at which the coated silver particles begin necking. Here, the necking of the coated silver particles means that the silver core particles are bonded to each other by separating the coating agent from the surface of the silver core particles. Since the necking causes a weight change accompanying the disappearance of the coating agent from the surface of the silver core particles, the weight change can be determined by a TG-DTA measurement, and the temperature (in the example of Fig. 3, the temperature is around 175 °C) at which the weight changes in the TG curve obtained by the TG-DTA measurement can be defined as the separation temperature. Note that the TG-DTA measurement is preferably performed under a condition in which, for example, 10 mg of a sample is heated from 50 °C at a temperature increasing rate of 5 °C per minute.

Examples of the coating agent that can be relatively easily separated from the surface of the silver core particles by temperature elevation include organic molecules such as an aliphatic carboxylic acid, an aliphatic aldehyde, an aliphatic alcohols, and an aliphatic amine. Among them, an aliphatic carboxylic acid is preferably used as the coating agent. The aliphatic carboxylic acid easily causes a monomolecular film to be formed on the surface of the silver core particles, because the carboxyl group side of the aliphatic carboxylic acid is adsorbed on the silver to coat the surface of the silver nucleus particles. Therefore, it is difficult to form several layers of molecular films outside the silver core particles, and desorption by temperature elevation is relatively easy. Aliphatic carboxylic acids are weakly bonded to silver core particles by physical adsorption, etc., and thus they are considered to diffuse and desorb at relatively low temperatures. Therefore, the surface of the silver core particles is easily exposed by heating, the surface of the silver core particles can be brought into contact with each other, and the coated silver particles can be sintered at a low temperature.

The aliphatic carboxylic acid suitably used as the coating agent is a compound having a structure in which one or more carboxyl groups are substituted for the aliphatic compound, and in this embodiment, the carboxyl groups of the aliphatic carboxylic acid are usually arranged on the surface of the silver core particles. Further, a compound having a structure in which one carboxyl group is substituted in an aliphatic compound, namely, a compound having an aliphatic hydrocarbon group and one carboxyl group is preferable.

The aliphatic hydrocarbon group constituting the aliphatic carboxylic acid is preferably a straight chain aliphatic hydrocarbon group, because a monomolecular film can be easily formed at a predetermined density on the surface of the silver core particles. An unsaturated bond may be a double bond or a triple bond, but preferably a double bond. In this embodiment, the aliphatic hydrocarbon group is preferably a saturated fatty acid having no unsaturated bond.

In the aliphatic carboxylic acid, the number of carbon atoms of the aliphatic group is preferably three or more, more preferably five or more, and still more preferably seven or more in terms of the dispersibility and oxidation resistance of the coated silver particles. On the other hand, the number of carbon atoms of the aliphatic group is preferably 17 or less, more preferably 16 or less, and still more preferably 11 or less. Since the number of carbon atoms is equal to or less than the above upper limit, the coated silver particles can be easily removed at the time of sintering, and a sintered body having excellent joining strength can be obtained. In the present disclosure, the number of carbon atoms of the aliphatic group does not include carbon atoms constituting the carboxyl group.

Specific examples of preferred aliphatic carboxylic acids include an octanoic acid, an undecanoic acid, a dodecanoic acid. The aliphatic carboxylic acid can be used alone or two or more kinds of the aliphatic carboxylic acids may be used in combination.

The aliphatic carboxylic acid is preferably arranged on the surface of the silver core particles at a density of 2.5 to 5.2 molecules per 1 $nm^2$. That is, the surface of the silver core particles is coated with a coating layer including the aliphatic carboxylic acid, and the coating density of the coating layer is 2.5 to 5.2 molecules/$nm^2$. In terms of dispersibility and oxidation resistance, the coating density is preferably 3.0 to 5.2 molecules/$nm^2$, and more preferably 3.5 to 5.2 molecules/$nm^2$.

In this embodiment, the coated silver particles preferably include, among others, silver core particles and a plurality of aliphatic carboxylic acid molecules arranged on the surface of the silver core particles at a density of 2.5 to 5.2 molecules per 1 $nm^2$. In the coated silver particles, the aliphatic carboxylic acid molecule is adsorbed on the surface of the silver nucleus particle at the carboxyl group side to form a monomolecular film. Therefore, it is presumed that the surface of the silver core particles is protected by the aliphatic carboxylic acid coating agent to suppress oxidation and thus has high oxidation resistance. For example, the proportion of the content of silver oxide and silver hydroxide in the coated silver particles after two months can be reduced to 5 mass% or less to 100 mass% of silver core particles in the coated silver particles. In addition, since aliphatic carboxylic acids are weakly bonded to silver core particles by physical adsorption, etc., they are considered to diffuse and desorb at relatively low temperatures. Therefore, since the surface of the silver core particles is easily exposed by heating and the surface of the silver core particles can be brought into contact with each other, the coated silver particles have excellent sinterability at a low temperature.

The coating density of the aliphatic carboxylic acid or the like on the surface of the silver core particles can be calculated based on the description of paragraphs 0014 to 0025 of Patent Literature 3 (Japanese Unexamined Patent Application Publication No. 2017-179403).

Specifically, according to the method disclosed in Japanese Unexamined Patent Application Publication No. 2012-88242, an organic component adhered to the surface of the coated silver particles is extracted using liquid chromatography (LC), and a component analysis is conducted. Further, a TG-DTA measurement is conducted to measure the amount of the organic component included in the coated silver particles. Next, the amount (mass) of the aliphatic carboxylic acid included in the coated silver particles is obtained together with the analysis result of the LC, and the number of molecules of the aliphatic carboxylic acid or the like is calculated.

The average primary particle diameter of the silver core particles is measured by an SEM image observation, and the surface area of the silver core particles is calculated. From these results, the coating density can be obtained by the following equation.

$$[Coating\ density] = [number\ of\ molecules\ such\ as\ aliphatic\ carboxylic\ acids]/[surface\ area\ of\ silver\ core\ particles]$$

The particle diameter of the coated silver particles can be appropriately selected according to the application or the like. The average primary particle diameter of the coated silver particles is preferably 1 to 500 nm, more preferably 5 to 400 nm, and still more preferably 20 to 300 nm.

The average primary particle diameter of the coated silver particles is calculated as an arithmetic average value $D_{SEM}$ of primary particle diameters of any 20 coated silver particles observed by SEM.

The value of the coefficient of variation (standard deviation SD/average primary particle diameter $D_{SEM}$) of the particle size distribution of the coated silver particles is, for example, 0.01 to 0.5, preferably 0.05 to 0.3. In particular, since the coated silver particles are produced by the method of producing coated silver particles described later, the coefficient of variation of the particle size distribution is small, and the particle size can be made uniform. Since the coefficient of variation of the particle size distribution of the coated silver particles is small, a dispersion element excellent in dispersibility can be obtained.

In this embodiment, the content ratio of the solder powder to the coated silver particles is 6:4 to 8:2 by mass. With such a ratio, a cured product having excellent joining strength and sealing performance can be obtained.

In this embodiment, the coated silver particles may be commercially available ones or produced. An example of the method of producing the coated silver particles will be described.

The coated silver particles can be produced, for example, by referring to, for example, paragraphs 0052 to 0101 and paragraphs 0110 to 0114 of Patent Literature 3. According to this production method, substantially spherical coated silver particles are obtained which include silver core particles and aliphatic carboxylic acid molecules arranged at a density of 2.5 to 5.2 molecules per $1 \text{ nm}^2$ on the surface of the silver core particles.

Specifically, first, a mixed solution including silver carboxylate including silver as the silver core particles, an aliphatic carboxylic acid that coats the surface of the silver core particles, and a solvent is prepared. The coated silver particles can be obtained by adding a complexing agent to the mixed solution and then heating the mixed solution.

Examples of the silver carboxylate include silver formate, silver oxalate, and silver carbonate.

Examples of the complexing agent include 2-aminoethanol, 3-amino-1-propanol, 5-amino-1-pentanol, DL-1-amino-2-propanol, N-methyl diethanolamine.

Examples of the above solvent include ethylcyclohexane, C9-based cyclohexane [made by Maruzen Petrochemical Co., Ltd., product name: Swaclean #150], and n-octane (boiling point: 125 °C, SP value: 7.54). These solvents may be used in combination with a glycol ether-based solvent such as methyl propylene diglycol.

<Solvent>

In the sealing composition according to this embodiment, the solvent can be suitably selected from the solvents in which the solder powder and the coated silver particles can be dispersed. In terms of the chemical stability and dispersibility of the solder powder and the coated silver particles, the solvent preferably includes one or more kinds of solvents selected from the group consisting of an aliphatic amine-based solvent, an aliphatic alcohol-based solvent, an aliphatic amino alcohol-based solvent, a terpin acetate-based solvent, an aliphatic alkane-based solvent, and a carbitol-based solvent. In this embodiment, the solvent can be used alone or a combination of two or more solvents may be used.

Examples of the aliphatic amine-based solvent include octylamine, decylamine, dodecylamine, and oleylamine.

Examples of the aliphatic amino alcohol-based solvent include ethanolamine, propanolamine, octanolamine, decanolamine, dodecanolamine, and oleyl alcohol amine.

Examples of the aliphatic alcohol-based solvent include hexanol, octanol, decanol, dodecanol, and oleyl alcohol.

Examples of the terpin acetate-based solvent include 1,8-terpin -1 acetate, 1,8-terpin-8 acetate, 1,8-terpin-1, and 8-diacetate.

Examples of the aliphatic alkane-based solvent include octane, decane, dodecane, and liquid paraffin.

Examples of the carbitol-based solvent include butyl carbitol, hexyl carbitol, and decyl carbitol.

Among them, it is preferable to include the terpin acetate-based solvent as the solvent. The sealing composition can be a composition suitable for screen printing by using the terpin acetate-based solvent. For example, terpene acetate-based solvents such as Terusolve THA-90 and Terusolve THA-70 of Nippon Terpene Chemicals, Inc. may be used.

In this embodiment, the boiling point (T3) of the solvent is equal to or higher than the sintering temperature (T2) of the coated silver particles. By using such a solvent, the coated silver particles continue to be sintered in a state in which the solvent remains in the sealing composition. Therefore, the coated silver particles have fluidity at the time of sintering, and it becomes difficult for holes to be generated in the sintered body. As a result, a sintered body excellent in adhesion and joining strength can be obtained. The boiling point (T3) of the solvent is preferably higher than the melting point (T1) of the solder powder. The reaction between the coated silver particles and the solder powder can be completed in a liquid phase by selectively using a solvent having a boiling point higher than the sintering temperature (T2) of the coated silver particles and the melting point (T1) of the solder powder (T3). It is thus possible to obtain a sintered body having excellent adhesion and sealing performance. Further, by using a solvent having a high boiling point, drying at the time of printing or after printing is suppressed, so that the usable time is prolonged. The boiling point (T3) of the solvent is preferably higher than the melting point of the solder powder, more preferably at or above 10 °C higher than the melting point of the solder powder, preferably at or under 100 °C higher than the melting point of the solder powder (the melting point (T3) of the solvent is preferbaly equal to or less than (the melting point of the solder powder + 100 °C)), more preferably at or under 90 °C higher than the melting point of the solder powder (the melting point (T3) of the solvent is more preferably equal to or less than (the melting point of the solder powder + 90 °C), and still more preferably at or under 85 °C higher than the melting point of the solder powder (the melting point (T3) of the solvent is still more preferably equal to or less than (the melting point of the solder powder + 85 °C)). When the solvent is a mixed solvent, the boiling point (T3) of the solvent is (T3), which is the boiling point of the solvent having the highest boiling point. This is because if at least a part of the solvent remains, it contributes to the above adhesion and sealing performance.

In this embodiment, when the solvent icnludes a terpinacetate-based solvent, the content ratio of the terpinacetate-based solvent is not particularly limited, but the content ratio of the terpinacetate-based solvent is preferably 50 mass% or more, more preferably 60 mass% or more, in the total amount of the solvent. The proportion of the content of the solvent to the total amount of the sealing composition is preferably 1 to 30 mass%, and more preferably 5 to 20 mass%.

[Method of using sealing composition]

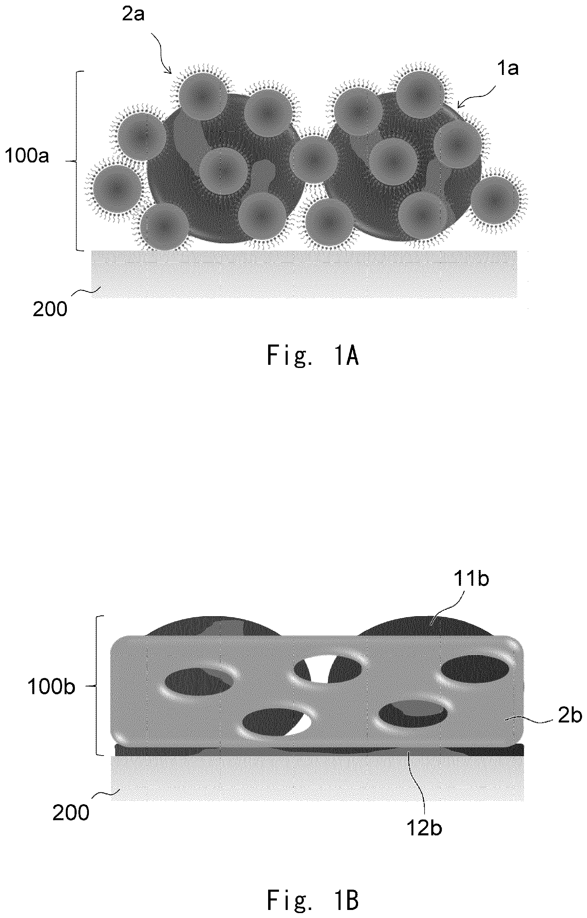

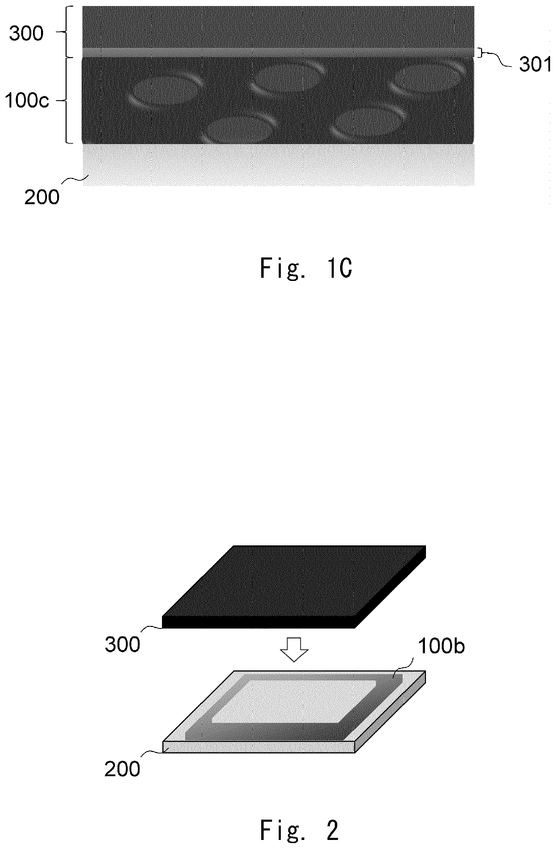

An example of the method of using the sealing composition according to this embodiment will be described with reference to the drawings. Figs. 1A to 1C are schematic process diagrams showing an example of the method of using the sealing composition according to this embodiment. Fig. 2 is a schematic diagram showing an example of the step of bonding a light source substrate to a semi-cured product of the sealing composition. For the purpose of explanation, the shape, particle diameter, distribution, and the like of the solder powder and the coated silver particles in the drawings are schematic, and the scale and the like may not match actual ones.

Fig. 1A is a schematic diagram showing an example of a sealing composition 100a applied onto a glass substrate 200. Fig. 1B is a schematic diagram showing an example of a sealing composition 100b in a semi-cured state (after B-staging) after heating the coating film of Fig. 1A at a temperature equal to or higher than the (T1) temperature and lower than (T2). Fig. 1C is a schematic diagram showing an example of a joined part after the joined part of a substrate (hereinafter also referred to as a light source substrate 300) including an optical element is arranged on the sealing composition after B-staging and heated at the temperature (T3) or higher.

In the example of Fig. 1A, the sealing composition 100a is applied onto the glass substrate 200 to form a coating film including a solder powder 1a, coated silver particles 2a, and a solvent (not shown). The coated silver particles 2a may be carried on the surface of the solder powder 1a as shown in the example of Fig. 1A or may be dispersed in the solvent. The method of coating the sealing composition may be suitably selected from known coating methods. For example, the sealing composition may be applied by a method such as screen printing, dispensing printing, stamping printing, etc. When the glass substrate is in the form of a plate, screen printing is preferable in terms of mass production with high accuracy.

The thickness of the coating film of the sealing composition is not particularly limited, but may be, for example, within the range of 30 to 100 μm. The line width of the coating film may be, for example, within the range of 100 to 500 μm. By setting the thickness and the line width of the coating film within the above ranges, a sintered body excellent in sealing performance and joining strength can be obtained. In order to seal the optical element, the coating film is formed in a predetermined frame shape as shown in Fig. 2.

In this embodiment, the glass substrate 200 is a member that functions as a window material for transmission light emitted from the optical element. In this embodiment, the glass substrate 200 is preferably synthetic quartz glass, because synthetic quartz glass can stably transmit light having a wavelength of 350 nm or less, particularly light having a wavelength of 300 nm or less. The shape of the quartz glass is not particularly limited, and may be plate-like or may include a known lens shape. The thickness of the quartz glass is not particularly limited, but may be, for example, 0.1 to 5 mm.

Next, the coating film of Fig. 1A is heated at a temperature equal to or higher than the melting point (T1) of the solder powder and lower than the sintering temperature (T2) of the coated silver particles. At this time, as shown in the example of Fig. 1B, the solder powder 1a is melted to form a melt 1b. At this time, airtightness with the glass substrate 200 can be improved by the wettability of the solder. In particular, when the solder powder includes Bi, Bi has excellent wettability to the glass, so that the adhesion between the sealing composition and the glass substrate 200 is improved. Thus, a B-stage sealant having a thick film and excellent adhesion is formed. The heating time for the B-staging is not particularly limited, but is, for example, 10 minutes or more, preferably 30 minutes or more. In this temperature range, the coated silver particles are not sintered and are dispersed inside the melt 1b.

Next, the glass substrate on which the B-stage sealant is formed may be bonded to the substrate included the optical element, or may be temporarily cooled and stored.

Next, as shown in the example of Fig. 2, the light source substrate 300 including an optical element to be sealed is arranged on the sealing composition 100b after B-staging. It is preferable that metal plating 301 such as gold plating be applied on the joining surface of the light source substrate 300. By joining the sealing composition to the plated part, a cured product having excellent adhesion, joining strength, and sealing performance can be obtained. Next, by heating the cured product while pressing it, the solder powder is melted, wetted, and spreaded on the surface of the light source substrate, thereby adhering to the light source substrate. Further, by heating the cured product at the sintering temperature (T2) of the coated silver particles, the coated silver particles included in the sealing composition 100b are sintered to form sintered silver. At this time, since the coated silver particles are sintered inside the molten solder, the molten solder is bonded to the sintered silver to form a cured product 100c. The cured material 100c has such a structure that holes 101c of sintered silver are filled with the solder, and is excellent in joining strength. In this manner, the glass substrate 200 and the light source substrate 300 can be bonded to each other with sufficient joining strength and sealing performance. The heating temperature at the time of joining the light source substrate can be, for example, 170 to 350 °C, and preferably 250 to 350 °C. By the heating at 250 °C or higher, it is presumed that an SnAg alloy is formed between the molten tin and the surface of the silver sintered body, and the joining strength is further enhanced. Further, by the heating at this temperature, sufficient joining strength and sealing performance can be obtained even by the heating for a short time of, for example, 10 to 60 seconds. However, the heating time is not particularly limited. The pressing condition is not particularly limited, but may be, for example, 0.01 to 1 kgf/mm$^2$, preferably 0.05 to 1 kgf/mm$^2$.

[Example]

Hereinafter, the present disclosure will be described in more detail with reference to examples, but the present disclosure is not limited to these examples.

(Production Example 1: Production of Coated Silver Particles Ag1)

Referring to Patent Literature 3, coated silver particles Ag1 having an undecanoic acid arranged on the surface of silver core particles at a coating density of 2.5 to 5.2 nm$^2$ were produced.

(Example 1: Preparation of Sealing Composition)

24 parts by mass of the coated silver particles Ag1, 64 parts by mass of SnBi alloy particles (made by Mitsui Mining & Smelting Co., Ltd., ST-3; particle diameter of about 3 μm), 8 parts by mass of Terusolve THA-70 (made by Nippon Terpene Chemicals, Inc.; boiling point (T3): 223 °C) and 4 parts by mass of 3-hydroxy-2, 2, 4-trimethylpentyl butyrate (made by Tokyo Chemical Industry Co., Ltd.) as the solvents were mixed to obtain the sealing composition according to Example 1.

(Comparative Example 1: Preparation of Comparative Sealing Composition)

A comparative sealing composition according to Comparative Example 1 was obtained in the same manner as in Example 1 except that silver particles having an average primary particle diameter of 1 μm were used instead of the coated silver particles Ag1 in Example 1. The sintering temperature of the silver particles was about 240 to 280 °C.

<TG-DTA measurement>

The sealing composition according to Example 1 was subjected to a TG-DTA measurement using TG8120 (made by Rigaku Corporation) under a nitrogen atmosphere (nitrogen flow rate: 250 ml/min) at a temperature increasing rate of 10 °C/min. The result of the TG-DTA measurement is shown in Fig. 3. From the result of Fig. 3, it was found that the melting point (T1) of the SnBi alloy particles was 143 °C. The sintering temperature (T2) of the coated silver particles Ag1 was found to be 160 to 185 °C.

<Joining strength evaluation>

The sealing composition according to Example 1 was applied onto a 5 mm square × 0.5 mm thick synthetic quartz glass substrate using a metal mask with an opening of 4 mm square × 0.05 mm thick, and then the synthetic quartz glass substrate was headed under atmospheric conditions at 150 °C for 60 minutes to thereby obtain a semi-cured product. A ceramic substrate having gold plating on the joining surface is arranged on the obtained semi-cured product. The semi-cured product was sandwiched between the synthetic quartz glass substrate and the ceramic substrate, and heated and sintered at 300 °C for 10 seconds while applying a pressure of 0.09 kgf/mm$^2$ in the thickness direction of the semi-cured product under an atmosphere to thereby obtain a joined body according to Example 1.
The comparative sealing composition according to Comparative Example 1 was applied onto a 5 mm square × 0.5 mm thick synthetic quartz glass substrate using a metal mask with an opening of 4 mm square × 0.05 mm thick, and then the synthetic quartz glass substrate was headed under atmospheric conditions at 150 °C for 60 minutes to thereby obtain a semi-cured product. A ceramic substrate having gold plating on the joining surface is arranged on the obtained semi-cured product. The semi-cured product was sandwiched between the synthetic quartz glass substrate and the ceramic substrate, and heated and sintered at 320 °C for 60 seconds while applying a pressure of 0.09 kgf/mm$^2$ in the thickness direction of the semi-cured product under an atmosphere to thereby obtain a joined body according to Comparative Example 1.

The joined bodies according to Example 1 and Comparative Example 1 were subjected to a die share test using a round spring type tension gauge made by Oba Keiki Seisakusho, K. K. and the joining strength was measured.

As a result, the joining strength of the joined body according to Example 1 was 8.0 MPa, and the joining strength of the joined body according to Comparative Example 1 was 1.5 MPa.

<Sealing Performance Evaluation>

A sliced, chamfered, lapped, rough-polished synthetic quartz glass wafer substrate (4 inch φ, 0.5 mm thick) was diced into 3.5 mm squares. The sealing composition obtained in Example 1 was applied onto one surface of a synthetic quartz glass wafer substrate by screen printing. The sealing composition was applied in a window frame shape so as to have a line width of 250 μm and a film thickness of 35 μm, and the sealing composition obtained in Example 1 was in a semi-cured state to thereby prepare a synthetic quartz glass lid. An LED light emitting element capable of emitting light with a wavelength of 285 nm is installed, and the synthetic quartz glass lid was pressed against a housing body of alumina nitride-based ceramics having a gold-plated joined part while being applied with a load of 0.03 kgf/mm$^2$ at 300 °C for 30 seconds, the housing body and the synthetic quartz glass lid were joined to thereby prepare an optical package.

Next, the prepared package for an optical element was left overnight in the microcheck permeation solution JIP 143 (made by Ichinen Chemicals Co. Ltd.,). After that, the package for an optical elements was washed with acetone and observed under a microscope, and it was found that no penetration of the microcheck permeation solution into the package was confirmed and that sufficient sealing performance was obtained.

From the above results, according to the sealing composition according to this embodiment including the solder powder, the coated silver particles, and the solvent having the boiling point of the coated silver particles equal to or higher than the sintering temperature, a sintered body having excellent joining strength and sealing performance can be obtained.

This application is based upon and claims the benefit of priority from Japanese patent application No. 2018-175739, filed on September 20, 2018, the disclosure of which is incorporated herein in its entirety by reference.

**Reference Signs List**

1a    SOLDER POWDER
1b    MELT
2a    COATED SILVER PARTICLES
100a    SEALING COMPOSITION
100b    B-STAGED SEALING COMPOSITION
100c    CURED PRODUCT
101c    HOLES IN SINTERED SILVER
200    GLASS SUBSTRATE
300    LIGHT SOURCE SUBSTRATE
301    METAL PLATING

**Claims**

1. A sealing composition comprising:

   a solder powder;
   coated silver particles comprising silver core particles and a coating agent arranged on a surface of the silver core particles; and
   a solvent, wherein
   a sintering temperature (T2) of the coated silver particles and a boiling point (T3) of the solvent satisfy a following Formula (1).

$$T2 \leq T3 \quad \ldots Formula\ (1)$$

2. The sealing composition according to Claim 1, wherein
   the coating agent comprises aliphatic carboxylic acid molecules.

3. The sealing composition according to Claim 2, wherein
   the aliphatic carboxylic acid molecules are arranged on the surface of the silver core particles at a density of 2.5 to 5.2 molecules per 1 nm$^2$.

4. The sealing composition according to any one of Claims 1 to 3, wherein
   the solder powder comprises at least one selected from a group consisting of an Sn-Bi-based solder, an Sn-Zn-Bi-based solder, and an Sn-Zn-based solder.

5. The sealing composition according to any one of Claims 1 to 4, wherein
   the solvent comprises at least one selected from a group consisting of an aliphatic amine-based solvent, an aliphatic alcohol-based solvent, an aliphatic amino alcohol-based solvent, a terpin acetate-based solvent, an aliphatic alkane-based solvent, and a carbitol-based solvent.

6. The sealing composition according to any one of Claims 1 to 5, wherein
   a content ratio of the solder powder to the coated silver particles is 6: 4 to 8: 2 by mass.

7. The sealing composition according to any one of Claims 1 to 6, wherein
   the melting point (T1) of the solder powder and the sintering temperature (T2) of the coated silver particles satisfy a following Formula (2).

$$T1 \leq T2 \quad \ldots Formula\ (2)$$

2a

1a

100a

200

Fig. 1A

11b

100b

2b

200

12b

Fig. 1B

300

301

100c

200

Fig. 1C

300

100b

200

Fig. 2

Fig. 3

## INTERNATIONAL SEARCH REPORT

| International application No. |
| --- |
| PCT/JP2019/034081 |

### A. CLASSIFICATION OF SUBJECT MATTER

Int.Cl. H01L33/56(2010.01)i, B22F1/00(2006.01)i, B22F1/02(2006.01)i, B22F3/02(2006.01)i, B22F9/00(2006.01)i, B23K35/26(2006.01)i, C22C12/00(2006.01)i, C22C13/02(2006.01)i, H01B1/00(2006.01)i, H01B1/22(2006.01)i, B22F9/24(2006.01)n

According to International Patent Classification (IPC) or to both national classification and IPC

### B. FIELDS SEARCHED

Minimum documentation searched (classification system followed by classification symbols)

Int.Cl. H01L33/56, B22F1/00, B22F1/02, B22F3/02, B22F9/00, B23K35/26, C22C12/00, C22C13/02, H01B1/00, H01B1/22, B22F9/24

Documentation searched other than minimum documentation to the extent that such documents are included in the fields searched

| | |
| --- | --- |
| Published examined utility model applications of Japan | 1922-1996 |
| Published unexamined utility model applications of Japan | 1971-2019 |
| Registered utility model specifications of Japan | 1996-2019 |
| Published registered utility model applications of Japan | 1994-2019 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| Y | WO 2017/007011 A1 (FURUKAWA ELECTRIC CO., LTD.) 12 January 2017, paragraphs [0021]-[0040], [0042]-[0064], [0116]-[0122], [0199], table 2 & US 2019/0019594 A1 paragraphs [0020]-[0039], [0044]-[0081], [0185]-[0198], [0343]-[0344], table 2 & CN 107848077 A | 1-7 |
| Y | JP 2017-179403 A (KYORITSU CHEMICAL & CO., LTD.) 05 October 2017, paragraphs [0008]-[0013], [0026], [0029]-[0062], [0109]-[0121] & US 2019/0076921 A1 paragraphs [0012]-[0023], [0050], [0059]-[0202], [0252]-[0264] & WO 2017/170023 A1 & EP 3437760 A1 & CN 108883466 A & KR 10-2018-0126468 A | 1-7 |

☒ Further documents are listed in the continuation of Box C.    ☐ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 22 November 2019 (22.11.2019) | 03 December 2019 (03.12.2019) |

| Name and mailing address of the ISA/ Japan Patent Office 3-4-3, Kasumigaseki, Chiyoda-ku, Tokyo 100-8915, Japan | Authorized officer Telephone No. |
| --- | --- |

Form PCT/ISA/210 (second sheet) (January 2015)

**INTERNATIONAL SEARCH REPORT**

International application No.

PCT/JP2019/034081

C (Continuation). DOCUMENTS CONSIDERED TO BE RELEVANT

| Category* | Citation of document, with indication, where appropriate, of the relevant passages | Relevant to claim No. |
|---|---|---|
| A | JP 2010-120089 A (SENJU METAL INDUSTRY CO., LTD.) 03 June 2010, paragraphs [0011]-[0017], [0019]-[0028] & US 2009/0301606 A1 paragraphs [0016]-[0031], [0034]-[0090] & WO 2006/126564 A1 & EP 1889683 A1 & KR 10-2008-0015874 A & CN 101208173 A & KR 10-1026970 B | 1-7 |
| A | JP 2017-110274 A (ITO KAGAKU KENKYUSHO CO., LTD.) 22 June 2017, paragraphs [0008]-[0013], [0019]-[0022] (Family: none) | 1-7 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5442566 B
- JP 2018026548 A
- JP 2017179403 A
- JP 2012088242 A
- JP 2018175739 A